# EUROPEAN PATENT APPLICATION

(11) **EP 1 601 005 A2**
(43) Date of publication of application: **30.11.2005**
(21) Application number: 05076250.9
(22) Date of filing: 27.05.2005
(51) Int. Cl.: H01L 21/00

(54) **Peeling device for chip detachment**

(30) Priority: 28.05.2004 US 857067
(71) Applicant: ASM Assembly Automation Ltd., Kwai Chung, Hong Kong (CN)
(72) Inventor: Cheung, Yiu Ming, Mei Foo Sun Chuen Hong Kong (CN); Chong, Chi Ming, Carado Garden New Territories Hong Kong (CN); Yiu, Ching Hong, Kowloon Hong Kong (CN)
(74) Representative: Griebling, Onno

(57) **Abstract**

A peeling device is provided for detachment of a chip from an adhesive tape on which it is mounted. The device comprises a platform including a first surface and a raised contact surface set at a determinate height with respect to the first surface. The raised contact surface has a width that is smaller than a width of the chip for contacting the adhesive tape at a position of the chip. Further, an elevation device is projectable from the raised contact surface and movable with respect to the platform for lifting the chip away from the adhesive tape.

## Description

### Field of the Invention

The invention relates to the detachment of a semiconductor chip from an adhesive film or tape to which it has been mounted for processing, and in particular, to an apparatus and method for partially peeling the chip from the film or tape prior to total removal therefrom.

### Background and Prior Art

During processing of semiconductor or integrated circuit chips or dice to produce semiconductor packages, the chips are typically fabricated first in the form of a wafer slice containing an array of chips. Thereafter, the chips are usually singulated in a dicing process to physically separate them from one another. Dicing is commonly carried out while the wafer is mounted onto an adhesive tape (such as Mylar film) secured by a wafer ring. After dicing, there is a need to detach each chip individually from the wafer and mount them onto a carrier such as a leadframe, printed wiring board ("PWB") substrate or another chip during chip bonding or flip chip processes.

Accordingly, the semiconductor chip detachment process is one of the key processes in electronic packaging in which each chip on a singulated wafer is picked and detached from the dicing adhesive tape for subsequent packaging. There are various methods that apply different mechanisms for the pick-up process.

A popular method is to use a vacuum collet as a pick-and-place device to remove each chip from the adhesive tape and to place it on the bonding location. However, due to interfacial adhesion between the chip and the adhesive tape, it is desirable that a degree of delamination takes place between the chip and the adhesive tape before actual chip removal is carried out. This is because if substantial interfacial adhesion remains, the vacuum collet may fail to pick up the chip reliably, or cracking of the chip may result.

A method comprising the use of an ejector assembly in conjunction with the vacuum collet is probably the most well-known for initiating the aforesaid delamination. In this method, an individual singulated chip is firstly aligned with a center of a supporting platform of a vacuum enclosure in which an ejector assembly is mounted for movement relative to the supporting platform and adapted to push the chips away from the adhesive tape. Vacuum suction is applied via a vacuum hole on the platform to hold the chip in position as well as to hold down the adhesive tape against the surface of the vacuum platform, while the ejector assembly is pushing the chip in an opposite direction.

In order, to propagate delamination between the chip and the adhesive tape, the ejector assembly may comprise an ejector pin, such as in US patent number 5,755,373 for a "Die Push-Up Device". The patent discloses a push-up needle that pushes up the chip while a wafer sheet is held in place by vacuum suction in order to facilitate separation of the chip from the wafer sheet. The vacuum suction provided by vacuum enclosure via holes on its platform and the mechanical force acting at the back of the chip by the push-up ejector pin induce bending moment on the chip as well as peeling stress between the interface of the chip and the plastic adhesive tape. The peeling stress at the interface will cause the delamination of the chip and the adhesive tape and hence the chip is detached from the adhesive tape. However, a problem with the use of an ejector pin such as the push-up needle described is that the surface area of the pin in contact with the chip is small and therefore the pinning effect of the pin is strong. While this method is applicable for a thick semiconductor chip (say, of a thickness greater than 0.2 mm) of smaller size (say, of a width of less than 2 mm), if thinner or larger dice are being handled, the bending moment in the chip may lead to chip crack failure.

In this traditional push-up ejection method, when the size of the chip gets bigger and/or thinner, there is a high chance that the chip cracks during the pick-up process. The chip cracking is initiated at the region of a high strain field, which is generated by the high bending moment of the chip before the delamination of the chip from the adhesive tape due to the localized pinning effect on the chip by the push-up pins. A solution to reduce the bending moment of the chip and to increase the peeling stress along the interface is to reduce the distance between push-up pin and the edges of the chip.

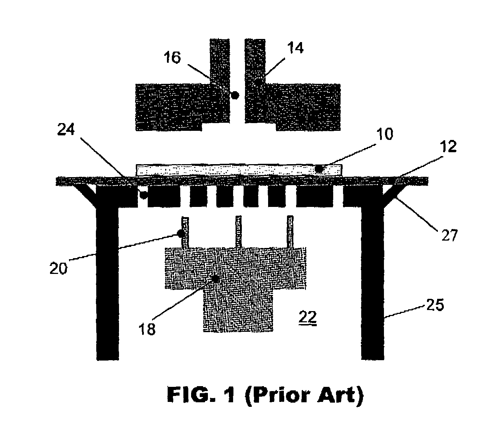

FIG. 1 is a cross-sectional side view of a prior art chip ejector mechanism including multiple ejector pins 20 that may be utilized to reduce the distance between the pins 20 and the edges of a chip 10 being detached. It comprises a collet 14 with a vacuum channel 16 to create vacuum suction, a vacuum enclosure 25 and an ejector chuck 18 with multiple ejector pins 20. The top surface of the vacuum enclosure 25 of the prior art generally rests flat against a bottom surface of the adhesive tape 12 holding the chip 10. In addition to the vacuum sealing ring 27 around the vacuum enclosure 25, there are a number of vacuum channels 24 formed on the vacuum enclosure 25 that are in fluid communication with a vacuum chamber 22 for generating vacuum suction to hold the chip 10 and adhesive tape 12 in position. After holding the chip 10 in position, the ejector pins 20 are made to move up to lift the adhesive tape 12 and the chip 10 for delaminating the chip 10 from the adhesive tape 12. At a predetermined height whereat the chip 10 is substantially delaminated from the adhesive tape 12, the collet 14 may pick up the chip 10 by vacuum suction. With multiple pins 20, the distance between the push-up pins and the edges of the chip 10 is reduced to reduce the aforesaid bending moment. However, the push-up pins 20 cannot be too close to the edge of the chip 10 since the pinning effect will activate microcracks (which are typically introduced by dicing of a wafer) along the chip edges. In addition, as compared to locating the push-up pins closer to the central region of the chip, the push-up pins located at the peripheral of the chip may inhibit the propagation of delamination into the center of a larger chip.

To reduce the risk of chip crack failure when using an ejector pin in conjunction with larger dice, US patent number 4,850,780 for a "Pre-Peel Die Ejector Apparatus" describes a two-stage process for chip separation. A die ejector chuck is provided with a central housing and an outer housing, and the central housing is provided with a central die eject collar which extends though an aperture in the outer housing. The central die eject collar is movable towards a preselected chip for detachment and away from the outer housing so as to stretch the flexible adhesive tape supporting the preselected chip, after which the chip is further separable from the adhesive tape by an ejector pin to permit the chip to be picked up with a vacuum collet. Such a two-stage process complicates the construction and application of the chip ejector apparatus and incurs an increased cycle time. It would be advantageous to provide a chip ejector comprising a simpler construction that is able to reduce the risk of chip crack when handling larger dice.

### Summary of the Invention

It is therefore an object of the invention to seek to provide an apparatus and method that is effective to peel a semiconductor chip from an adhesive tape while reducing the risk of chip crack failure for larger or thinner chips. It is also an object of the invention to seek to provide such an apparatus and method that is of a simpler construction as compared to the prior art to efficiently detach larger or thinner chips.

According to a first aspect of the invention, there is provided peeling device for detachment of a chip from an adhesive tape on which it is mounted, comprising: a platform including a first surface and a raised contact surface set at a determinate height with respect to the first surface, the raised contact surface having a width that is smaller than a width of the chip for contacting the adhesive tape at a position of the chip; and an elevation device projectable from the raised contact surface and movable with respect to the platform for lifting the chip away from the adhesive tape.

According to a second aspect of the invention, there is provided a method of detaching a chip from an adhesive tape on which it is mounted, comprising the steps of: contacting a raised contact surface of a platform against the adhesive tape at a position of the chip, wherein the raised contact surface is set at a determinate height with respect to a first surface of the platform and a width of the raised contact surface is smaller than a width of the chip; projecting an elevation device from the raised contact surface; and lifting the chip with the elevation device.

It will be convenient to hereinafter describe the invention in greater detail by reference to the accompanying drawings which illustrate one embodiment of the invention. The particularity of the drawings and the related description is not to be understood as superseding the generality of the broad identification of the invention as defined by the claims.

### Brief Description of the Drawings

An example of an apparatus and method according to the preferred embodiment of the invention will now be described with reference to the accompanying drawings, in which:
FIG. 1 is a cross-sectional side view of a prior art chip ejector assembly;
FIG. 2 (a) is a cross-sectional side view of a chip ejector assembly according to the preferred embodiment of the invention;
FIG. 2 (b) is a cross-sectional side view of the chip ejector assembly when peeling induced by vacuum suction occurs;
FIG. 3 is a plan view of a plurality of chips arranged on an adhesive tape with the chip ejector assembly of FIG. 2 (a) positioned underneath a chip to be detached;
FIG. 4 is a cross-sectional side view of the chip ejector assembly wherein the relative dimensions of the chip and chip ejector assembly are represented; and
FIG. 5 is a plan view of the plurality of chips as in FIG. 3 including representations of the positions of ejector pins mounted in the chip ejector assembly.

### Detailed Description of the Preferred Embodiment

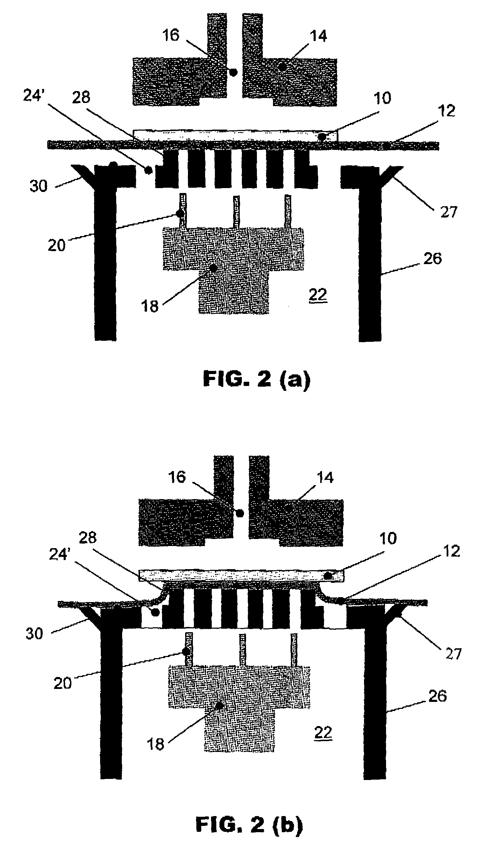

FIG. 2 (a) is a cross-sectional side view of a peeling device in the form of a chip ejector assembly according to the preferred embodiment of the invention. It comprises a platform, which may be in the form of a vacuum enclosure 26, enclosing an elevation device such as an ejector chuck 18 and a vacuum chamber 22. A vacuum collet 14 having a vacuum path 16 to generate vacuum force is provided for picking up a chip 10 mounted on an adhesive tape 12. The ejector chuck 18 preferably has multiple ejector pins 20. In particular, the vacuum enclosure 26 includes a raised contact surface in the form of a stepped extrusion 28 at the central region of a first surface or top platform 30 of the said vacuum enclosure 26.

The stepped extrusion 28 is in a relatively fixed position on the first surface or top platform 30, and moves together with the top platform 30. The geometry of the stepped extrusion 28 may provide a vacuum peeling mechanism to assist the detachment of the semiconductor chip 10 from the flexible plastic adhesive tape 12.

The stepped extrusion 28 and the top platform 30 respectively provide geometrical support to the semiconductor chip 10 to be picked up and to the surrounding chips. A width of the stepped extrusion 28 is smaller than a width of the chip 10 so that delamination may be initiated between the portions of the adhesive tape not in contact with the stepped extrusion 28. Most preferably, both widths of the stepped extrusion 28 are smaller than the widths of the chip 10. Vacuum channels 24' are constructed on the top platform 30 around the stepped extrusion 28 so that the adhesive tape 12 and hence the adhered semiconductor chips 10 are held in position relative to the stepped extrusion 28 and the top platform 30 by vacuum suction. Further, vacuum channels 24 are formed in the stepped extrusion to hold the adhesive tape 12 against the stepped extrusion 28. When vacuum suction is applied to the vacuum chamber 22, the adhesive tape 12 will be held down by the vacuum suction so that it conforms to the geometries of the stepped extrusion 28 and top platform 30. This will provide a peeling effect to initiate the delamination of the interface between the adhesive tape and the respective edges of the chip 10 not supported by the stepped extrusion 28.

Figure 2 (b) shows the effect of peeling in the interface between the semiconductor chip 10 and adhesive tape 12 induced by vacuum suction from a suction device. The suction device comprises vacuum channels 24' coupled to a vacuum source that are formed on the top platform 30 adjacent to the stepped extrusion 28. Delamination of this interface occurs when the adhesive tape 12 is drawn towards the top platform 30 of the vacuum enclosure 26 around the stepped extrusion 28 in the presence of vacuum suction generated via the vacuum channels 24'. Further or alternatively, the stepped extrusion 28 may be moved upwards in an additional upward stroke to lift the chip 10 and induce separation of the adhesive tape 12 from the chip 10 with or without the application of vacuum suction via the vacuum channels 24'.

A seal ring 27 is arranged on the vacuum enclosure 26 and is preferably located along a periphery of the vacuum enclosure 26. The highest point of the seal ring 27 is configured to be lower than the height of the stepped extrusion 28 and may be level with the top platform 30. As the vacuum source is turned on, there is a pressure differential in the vicinity inside the seal ring 27 as compared to the surrounding atmosphere. The pressure differential deforms the adhesive tape 12 so that the seal ring 27 encloses an area of the adhesive tape 12 that is drawn towards the vacuum enclosure 26. The vacuum force is enhanced as the adhesive tape 12 is held down tightly against the seal ring 27.

The said delamination will start from the edges and corners of the chip 10 as the adhesive tape 12 is peeled away from the chip 10, while the stepped extrusion 28 keeps a portion of the adhesive tape 12 corresponding to the centre of the chip 10 relatively flat. The vacuum channels 24' are specifically located in dose proximity to the straight edges of the stepped extrusion 28 on the top platform 30 to provide vacuum suction force for effective peeling.

The ejector assembly takes advantage of a combination of mechanical parts motion and vacuum suction. At the beginning of the pick-up cycle, the vacuum collet 14 descends and lands on the top surface of a semiconductor chip 10. Before the ejector pin(s) project up through the stepped extrusion 28, vacuum suction is applied via the vacuum channels 24' on the vacuum enclosure 26. This vacuum suction and the straight edges of the stepped extrusion 28 initiate the delamination of interface between the adhesive tape 12 and the chip 10 at the edges and corners of the semiconductor chip 10 being picked. After a pre-determined delay, the ejector pins 20 of the ejector chuck 18 are projected from the surface of the vacuum enclosure 26, more specifically from the stepped extrusion 28. which is underneath the chip 10 and the adhesive tape 12. The position of the multiple ejector pins 20 with respect to the vertical edges of the stepped extrusion 28 then allows further delamination of the chip 10 from the adhesive tape 12 by lifting the chip 10 away from the adhesive tape 12.

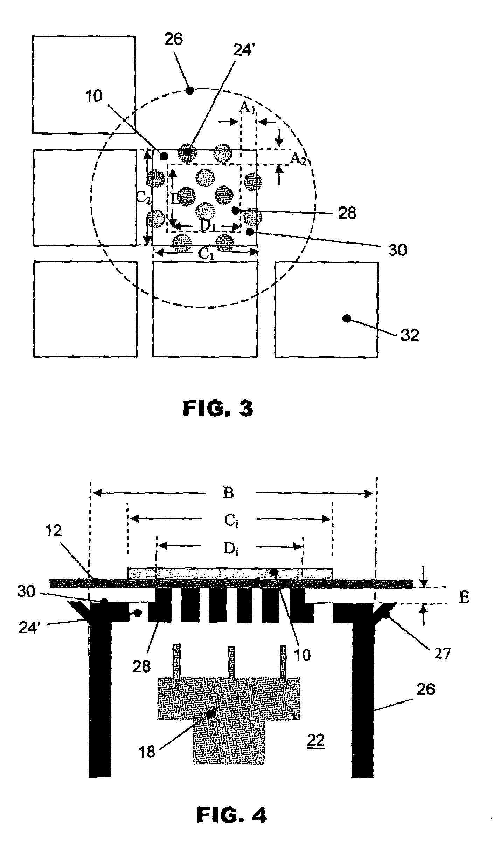

In order to obtain a satisfactory peeling effect by vacuum suction, the dimensions of the stepped extrusion 28 of the chip ejector assembly are preferably chosen according to certain guidelines as set out below. FIG. 3 is a plan view of a plurality of chips arranged on an adhesive tape with the chip ejector assembly of FIG. 2 (a) positioned underneath a chip to be detached. FIG. 4 is a cross-sectional side view of the chip ejector assembly wherein the relative dimensions of the chip and chip ejector assembly are represented. The planar dimension of the stepped extrusion 28 is smaller than the planar dimension of the semiconductor chip 10. The distance between the edge of the chip and the edge of the extrusion (A₁ and A₂ in FIG. 3) is designed within a specific range. The said distance (A₁ and A₂) depends on the thickness of the chip 10 and the adhesion strength of the adhesive tape 12. The step height, E, of the stepped extrusion 28 is also kept within a specific value (within a range 0.1-0.66 mm for a chip with a thickness of 0.05mm-0.5mm and a width of less than 10 mm) in order to have an optimal peeling angle as well as maximum energy useable for peeling the flexible plastic adhesive tape. It also helps to provide efficient and effective formation of the vacuum suction force. Keeping the step height E within the said range further helps to keep the deformation strain or stress below the chip's critical value at a given pressure loading. The edges of the stepped extrusion 28 should be rounded at a radius of about 0.1 mm in order to reduce the excessive stress/strain concentration of the chip 10 at these locations.

Referring to FIG. 3, for a semiconductor chip 10 with a planar dimension C₁ x C₂, the planar dimension of the extrusion D₁ x D₂ is chosen such that 0.3mm < Aᵢ < 2mm; and 1mm < Dᵢ < 10mm (where i = 1, 2). Referring to FIG. 4, the height E of the stepped extrusion 28 is 0.1 < E < 0.66 mm. The width of the vacuum enclosure B is in the range of (½B - ½Cₘ) < 10 mm, where Cₘ = max (C₁, C₂), in order to have effective vacuum sealing between the vacuum enclosure 26 and the adhesive tape 12.

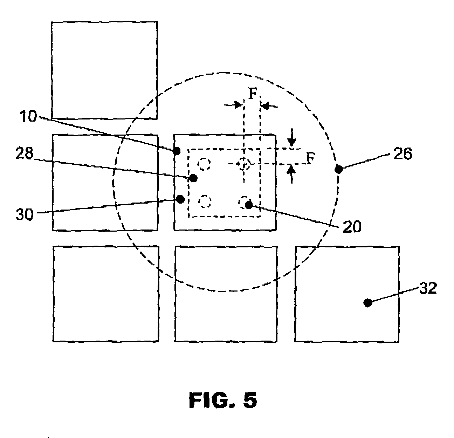

FIG. 5 is a plan view of the plurality of chips as in FIG. 3 including representations of the positions of ejector pins 20 mounted in the chip ejector assembly- Using the stepped extrusion 28 on top of the vacuum enclosure 26 as a peeling mechanism, the outer region of the chip 10 will be detached from the adhesive tape 12 when vacuum suction is applied through the vacuum channels 24' in the top platform 30 around the sides of the stepped extrusion 28. The ejection pins 20 will then elevate from the top surface of the stepped extrusion 28 to a pre-determined height above the stepped extrusion 28 of the vacuum enclosure 26. The adhesive tape will detach from the chip completely with the only contact area supported by the pins. Referring to FIG. 5, the ejector pins 20 are located with a specific distance F from the edges of the stepped extrusion 28 such that F < 1 mm.

An exemplary pick-up sequence that can be employed with the above embodiment of the invention is now described as follows:
*Step 1*. At the beginning of the pick-up cycle, the vacuum enclosure 26 is placed into contact with the underside of an adhesive tape 12 on which the chip 10 to be pick is mounted. The chip 10 is positioned such that the center of the chip 10 is aligned with the center of the vacuum enclosure 26, which also coincides with the center of the stepped extrusion 28.
*Step 2*. The pick-up collet 14 descends and lands on the top surface of the chip 10 to be picked up. The lower surface of the collet 14 may be in contact with the chip 10 or a very small gap may be maintained from the surface of the chip 10. Vacuum suction is applied to the collet 14 via the vacuum path 16. The chip 10 is then held by the collet 14 and its horizontal position is fixed.
*Step 3*. Vacuum suction is then applied via the vacuum channels 24' of the vacuum enclosure 26 including the stepped extrusion 28 and top platform 30. The resulting effect of vacuum suction and the straight edges of the stepped extrusion 28 initiates interfacial delamination between the adhesive tape 12 and the chip 10 starting at the edges and corners of the chip 10. The magnitude of vacuum suction is optimized to obtain effective peeling of the chip 10 from the adhesive tape 12 without introducing excessive strain on the chip 10 that might cause crack chip failure.
*Step 4*. After a pre-determined delay to an order of 50 ms or more, the ejector pins 20 underneath the adhesive tape 12 will elevate from the top surface of the stepped extrusion 28 so as to lift the adhesive tape 12 and the chip 10. Portions of the adhesive tape 12 located inside the stepped extrusion 28 will be lifted higher than the portions outside the stepped extrusion 28. As a result the chip 10 being picked up is substantially delaminated from the adhesive tape 12, with the only contact between the chip 10 and the adhesive tape 12 primarily supported by the ejector pins 20.
*Step 5.* Finally, the collet 14 holding the chip 10 by vacuum suction will move upwards and remove the chip 10 from the adhesive tape 12 to a designated location for a subsequent bonding process.

It would be appreciated that the straight edges of stepped extrusion 28 and vacuum suction provides a peeling mechanism to initiate the delamination of the interface between the adhesive tape 12 and the semiconductor chip 10. This vacuum-assisted peeling mechanism reduces the deformation of the chip as compared to simply pushing against the chip during initial peeling and hence reduces the stress induced on the semiconductor chip so that chip cracking failure can be avoided. Together with the specific arrangement of the ejector pin(s), a more effective detachment mechanism is provided for detaching a semiconductor chip from an adhesive tape as compared to the prior art.

In view of the aforesaid advantages of the assembly according to the preferred embodiment of the invention, the assembly is ideally used in a pick-up process for a semiconductor chip having planar surface areas of more than 2x2 mm² (but less than 10x10mm²) and with thickness of less than 0.15 mm, which is mounted onto an adhesive tape 12 with an adhesion strength of less than 30 J/m².

The invention described herein is susceptible to variations, modifications and/or additions other than those specifically described and it is to be understood that the invention includes all such variations, modifications and/or additions which fall within the spirit and scope of the above description.

## Claims

1. A peeling device for detachment of a chip from an adhesive tape on which it is mounted, comprising:
a platform including a first surface and a raised contact surface set at a determinate height with respect to the first surface, the raised contact surface having a width that is smaller than a width of the chip for contacting the adhesive tape at a position of the chip; and
an elevation device projectable from the raised contact surface and movable with respect to the platform for lifting the chip away from the adhesive tape.

2. The peeling device as claimed in claim 1, including a suction device coupled to the first surface for drawing a portion of the adhesive tape not in contact with the raised contact surface towards the platform.

3. The peeling device as claimed in claim 2, wherein the suction device comprises vacuum channels coupled to a vacuum source that are formed on the first surface adjacent to the raised contact surface.

4. The peeling device as claimed in claim 2 or claim 3, including a seal ring arranged on the platform that is adapted to enclose an area of the adhesive tape that is drawn towards the platform.

5. The peeling device as claimed in claim 4, wherein the seal ring is located along a periphery of the platform.

6. The peeling device as claimed in claim 4 or claim 5, wherein a highest point of the seal ring is configured to be lower than the height of the raised contact surface.

7. The peeling device as claimed in any one of the preceding claims, including vacuum channels formed in the raised contact surface that are coupled to a vacuum source.

8. The peeling device as claimed in any one of the preceding claims, including a collet that is positionable over the chip for supporting the chip during separation of the adhesive tape from the chip.

9. The peeling device as claimed in any one of the preceding claims, wherein the height of the raised contact surface is between 0.1 mm to 0.66mm and the width of the chip is less than 10mm.

10. The peeling device as claimed in any one of the preceding claims, wherein an edge of the raised contact surface is rounded to a radius of about 0.1mm.

11. The peeling device as claimed in any one of the preceding claims, wherein the width of the raised contact surface is between 1mm to 10mm and the distance between the edge of the raised contact surface to an unsupported edge of the chip is between 0.3mm to 2mm.

12. The peeling device as claimed in any one of the preceding claims, wherein the difference between the width of the raised contact surface and the width of the platform is less than 10mm.

13. The peeling device as claimed in any one of the preceding claims, wherein the elevation device comprises one or more push-up pins.

14. The peeling device as claimed in claim 13, wherein at least one of a plurality of push-up pins is arranged such that the distance of the push-up pin of the elevation device from an edge of the chip is less than 1 mm.

15. Method of detaching a chip from an adhesive tape on which it is mounted, comprising the steps of:
contacting a raised contact surface of a platform against the adhesive tape at a position of the chip, wherein the raised contact surface is set at a determinate height with respect to a first surface of the platform and a width of the raised contact surface is smaller than a width of the chip;
projecting an elevation device from the raised contact surface; and
lifting the chip with the elevation device.

16. Method as claimed in claim 15, including the step of drawing a portion of the adhesive tape around the raised contact surface that is not contacted by the raised contact surface away from the chip prior to lifting the chip with the elevation device.

17. Method as claimed in claim 16, including enclosing an area of the adhesive tape drawn away from the chip with a seal ring arranged on the platform.

18. Method as claimed in claim 16 or claim 17, wherein the adhesive tape is drawn away and separated from the chip using vacuum suction.

19. Method as claimed in claim 18, induding the steps of forming vacuum channels in the first surface adjacent to the raised contact surface, and coupling the vacuum channels to a vacuum suction to create a vacuum suction force at the vacuum channels.

20. Method as claimed in any one of claims 15 to 19, including the step of positioning a collet over the chip for supporting the chip during separation of the adhesive tape from the chip.
